# EUROPEAN PATENT APPLICATION

(11) **EP 4 654 256 A1**
(43) Date of publication of application: **26.11.2025**
(21) Application number: 25174921.4
(22) Date of filing: 07.05.2025
(51) Int. Cl.: H01L 23/00

(54) **WET-TACK SINTERING METHOD AND APPARATUS**

(30) Priority: 21.05.2024 US 202418669797
(71) Applicant: ASMPT Singapore Pte. Ltd., Singapore 768924 (SG)
(72) Inventor: KUAH, Teng Hock, 768924 Singapore (SG); DING, Jiapei, 768924 Singapore (SG); OOI, Chong Shyan, 768924 Singapore (SG); LIN, Yi, 768924 Singapore (SG)
(74) Representative: Emerson, Peter James

(57) **Abstract**

Prior to sintering a component to a carrier, a portion of a sintering surface at or adjacent to a first side of the component is caused to contact a sintering paste applied on the carrier when a second side of the component that is opposite to the first side is supported by a support mechanism, such that the sintering surface of the component is tilted relative to the carrier. The support member is then moved to gradually reduce a distance between the second side of the component and the carrier so as to cause a remainder of the sintering surface of the component to contact the sintering paste. Therefore, air that is present between the component and the sintering paste may be removed before the component is sintered to the carrier.

## Description

### Field of the Invention

The invention generally relates to a sintering process for microelectronic devices, and more specifically to a method and apparatus for conducting a wet-tack sintering process.

### Background

There are two primary sintering methods: dry-tack sintering and wet-tack sintering. While dry-tack sintering can be used for manufacturing most products, wet-tack sintering offers certain advantages due to its ease of handling, such as the ability to attain uniform thickness. However, the challenge in conducting wet-tack sintering lies in accurately maintaining the position, both horizontally and vertically, of the components being bonded onto the liquid sintering paste before the sintering paste solidifies. Specifically, when placing a component onto a carrier on which the liquid sintering paste has already been applied, air may be trapped between the component and the sintering paste due to the surface tension of the sintering paste. The trapped air can eventually lead to the formation of internal voids in the sintered package, resulting in poor product quality and electrical performance.

It would therefore be beneficial to provide a new solution for the wet-tack sintering process that can address the problems faced with trapped air in the conventional method mentioned above.

### Summary of the Invention

It is thus an object of the invention to seek to provide an improved wet-tack sintering method and apparatus that can avoid the entrapment of air between a sintering unit (e.g., a component) and a sintering paste when bonding the component onto the sintering paste, thereby enhancing the quality and performance of the sintered product.

According to a first aspect of the present invention, there is provided a method for sintering a component to a carrier. The method includes the steps of causing a portion of a sintering surface at or adjacent to a first side of the component to contact a sintering paste applied on the carrier when a second side of the component that is opposite to the first side is supported by a support mechanism such that the sintering surface of the component is tilted relative to the carrier, moving the support mechanism from a first position where the supporting mechanism is supporting the second side of the component towards a second position to gradually reduce a distance between the second side of the component and the carrier so as to cause a remainder of the sintering surface of the component to contact the sintering paste, whereby air that is present between the component and the sintering paste is removed, and sintering the component to the carrier when the remainder of the sintering surface of the component is resting on the sintering paste.

According to a second aspect of the present invention, there is provided an apparatus for sintering a component to a carrier. The apparatus includes a support mechanism configured to support a second side of the component that is opposite to a first side of the component when a portion of a sintering surface at or adjacent to the first side of the component is contacting a sintering paste applied on the carrier such that the sintering surface of the component is tilted relative to the carrier, wherein the support mechanism is movable from a first position where the support mechanism is supporting the second side of the component towards a second position to gradually reduce a distance between the second side of the component and the carrier so as to cause a remainder of the sintering surface of the component to contact the sintering paste, whereby air that is present between the component and the sintering paste is removed, before the component is sintered to the carrier when the remainder of the sintering surface of the component is resting on the sintering paste.

These and other features, aspects, and advantages will become better understood with regard to the description section, appended claims, and accompanying drawings.

### Brief Description of the Drawings

Embodiments of the present invention will now be described, by way of example only, with reference to the accompanying drawings, in which:
FIG. 1 shows a side view of an apparatus for sintering a component to a carrier according to a first embodiment of the invention.
FIG. 2 shows a side view of an apparatus for sintering a component to a carrier according to a second embodiment of the invention.
FIG. 3A to FIG. 3E illustrate a method for sintering a component to a carrier with the apparatus shown in FIG. 2 according to one embodiment of the invention.
FIG. 4A to FIG. 4F illustrate a method for sintering a component to a carrier with the apparatus shown in FIG. 2 according to another embodiment of the invention.

In the drawings, like parts are denoted by like reference numerals.

### Detailed Description of the Preferred Embodiments of the Invention

Embodiments of the invention provide a wet-tack sintering apparatus and method for sintering a component to a carrier. In this invention, a movable support mechanism is used for tilting the component relative to the carrier when placing the component onto a sintering paste applied onto the carrier so as to avoid entrapment of air between the component and the sintering paste. A quality of the sintered package and product can be improved as a result.

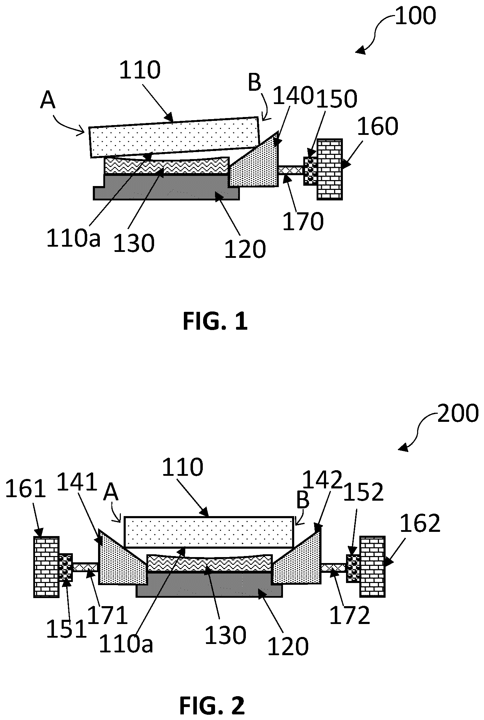

FIG. 1 shows a side view of an apparatus 100 for sintering a component 110 to a carrier 120 according to a first embodiment of the invention. The apparatus 100 includes a movable support mechanism. In this embodiment, the movable support mechanism includes a single movable support member 140. In one example, the support mechanism may further include an actuator 150 coupled to the support member 140 to activate the movement of the support member 140. The support mechanism may further include a mounting member 160 on which the actuator 150 is securely mounted.

The component 110 has two opposite sides A and B. During a sintering process, a portion of a sintering surface 110a at or adjacent to side A of the component 110 is caused to contact a sintering paste 130 which has been applied onto the carrier 120, while side B of the component 110 is placed on the support member 140 which is located at a first position to support side B of the component 110. In this embodiment, sides A and B of the component 110 may be simultaneously lowered or be lowered consecutively as aforesaid in a predetermined sequence onto the sintering paste 130 and the support member 140. The apparatus 100 may further include a transfer arm (not shown in FIG. 1) for picking up the component 110 from a predetermined location, placing the portion of the sintering surface 110a at or adjacent to side A onto the sintering paste 130 and placing side B of the component 110 on the support member 140.

Referring to FIG. 1, side B of the component 110 is supported by the support member 140 at the first position at a greater height situated position away from the sintering paste 130 and side A is at a lower height, the component 110 is therefore tilted relative to the sintering paste 130 and the carrier 120. Accordingly, the sintering surface 110a is positioned at an angle with respect to the carrier 120. To allow the entire sintering surface 110a of the component 110a to contact the sintering paste 130 prior to sintering the component 110 to the carrier 120, the support member 140 is moved from the first position to a second position to gradually reduce a distance between side B of the component 110 and the carrier 120 so as to cause a remainder of the sintering surface 110a of the component 110 to come into gradual contact with the sintering paste 130. With the movement of the support member 140, the sintering surface 110a remains tilted relative to the carrier 120 until it makes full contact with the sintering paste 130, thereby avoiding entrapment of air between the component 110 and the sintering paste 130. In other words, any air that may potentially be trapped between the component 110 and the sintering paste 130 while placing the component 110 onto the sintering paste 130 can be pushed out with the inclined lowering of the support member 140. After the sintering surface 110a is fully in contact with the sintering paste 130, the component 110 is sintered to the carrier 120 in a sintering process, where heat is applied to the sintering paste 130 to cure it while a load is being applied to the component 110.

In the first embodiment, the support mechanism only has one movable support member. However, in other embodiments, the support mechanism may have more than one movable support member configured to support the component during the sintering process.

FIG. 2 shows a side view of an apparatus 200 for sintering the component 110 to the carrier 120 according to a second embodiment of the invention. The apparatus 200 includes a movable support mechanism. In this embodiment, the movable support mechanism includes movable first and second support members 141 and 142, actuators 151 and 152 respectively coupled to the respective support members 141 and 142 and mounting members 161 and 162 for securely installing the actuators 151 and 152. The actuators 151 and 152 may comprise rotary or linear motors.

In this embodiment, the first support member 141 is movable between a first position where the first support member 141 is configured to support side A of the component 110 and a second position where the first support member 141 is located away from the component 110 to allow a portion of a sintering surface 110a of the component 110 at or adjacent to side A to contact the sintering paste 130 located on the carrier 120. The second support member 142 is movable between a third position where the second support member 142 is configured to support side B of the component 110 and a fourth position where the second support member 142 is located away from the component 110 to allow a portion of the sintering surface 110a of the component 110 at or adjacent to side B to contact the sintering paste 130 located on the carrier 120.

During a sintering process, one of the support members 141 and 142 is operative to first move from the first or third position to the second or fourth position in directions away from the carrier 120 to cause a portion of the sintering surface 110a of the component 110 to contact the sintering paste 130 first. Subsequently, the other one of the support members 141 and 142 is moved from the first or third position towards the second or fourth position away from the carrier 120 to cause the remainder of the sintering surface 110a of the component 110 to fully contact the sintering paste 130 so that the component 110 is resting on the sintering paste 130. Thus, due to the movements of the two support members 141 and 142, the sintering surface 110a of the component 110 remains tilted relative to the carrier 120 before the component 110 fully contacts the sintering paste 130. This allows any air trapped between the sintering paste 130 and the sintering surface 110a to be pushed out before the sintering surface 110a fully makes contact with the sintering paste 130.

As shown in FIG. 1 and FIG. 2, to facilitate gradual lowering of the component 110 by the support members 140, 141, 142, the support members 140, 141, 142 are wedge-shaped and have inclined surfaces for contacting side A or side B of the component 110. It should be noted that the shape of the support member is provided for illustrative purposes only and is not meant to limit the scope of the invention. In other embodiments, the shape of the support member may vary such as being rectangular without the inclined surface, and the component 110 may be lowered simply by directly moving or lowering the support members 140, 141, 142.

In the first and second embodiments, the support members 140, 141 and 142 may be coupled to the actuators 150, 151 and 152 by telescopic connecting rods 170, 171 and 172. The actuators 150, 151 and 152 are operative to move the connecting rods between a retracted state and an extended state, thereby moving the support members 140, 141 and 142 to different positions between and towards their end positions.

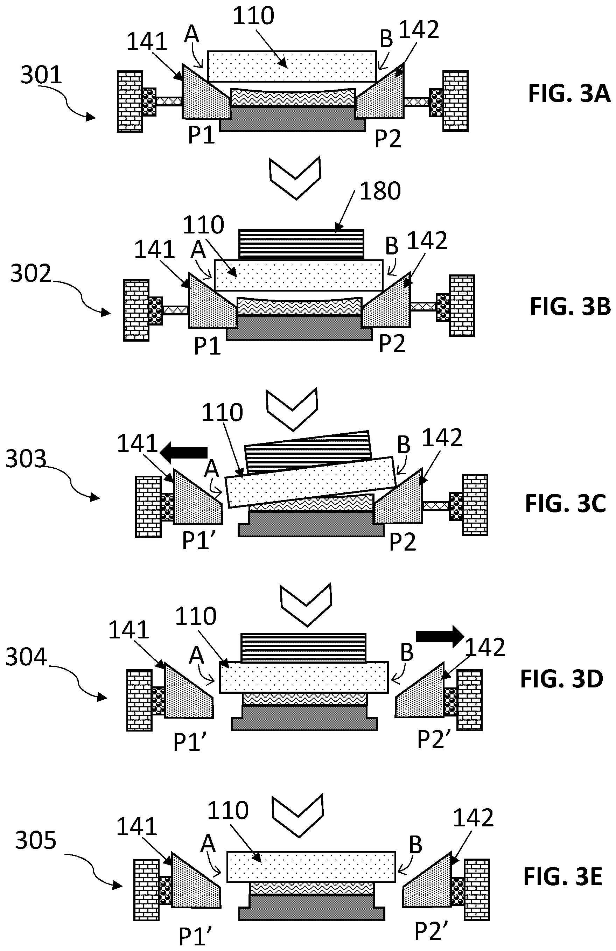

FIG. 3A to FIG. 3E illustrate a method for sintering the component 110 to the carrier 120 with the apparatus 200 shown in the second embodiment of the invention. Referring to FIG. 3A to FIG. 3E, in this embodiment, the method for sintering the component 110 to the carrier 120 includes the following steps:
In Step **301,** the component 110 is placed on the first and second support members 141 and 142. The first support member 141 is located at position P1 to support side A of the component 110 and the second support member 142 is located at position P2 to support side B of the component 110. Sides A and B of the component 110 may be placed onto both the first and second support members 141, 142 at the same time.
In Step **302,** a load such as a block 180 having a predetermined weight is placed onto the component 110. The block 180 acts as a deadweight.
In Step **303,** the first support member 141 is moved from position P1 to position P1' to reduce a distance between side A and the carrier 120 so as to cause a portion of the sintering surface 110a at or adjacent to side A of the component 110 to contact the sintering paste 130 first.
In Step **304,** the second support member 142 is moved from position P2 to position P2' to gradually reduce a distance between side B of the component 110 and the carrier 120 so as to cause the remainder of the sintering surface 110a of the component 110 to gradually contact the sintering paste 130 as the orientation of the component 110 becomes more horizontal. During the movement of the second support member 142, the sintering surface 110a remains mostly tilted relative to the carrier 120 to remove air between the component 110 and the sintering paste 130 as side B is gradually lowered.
In Step **305,** the component 110 is sintered to the carrier 120, and the block 180 may then be removed from the top surface of the component 110.

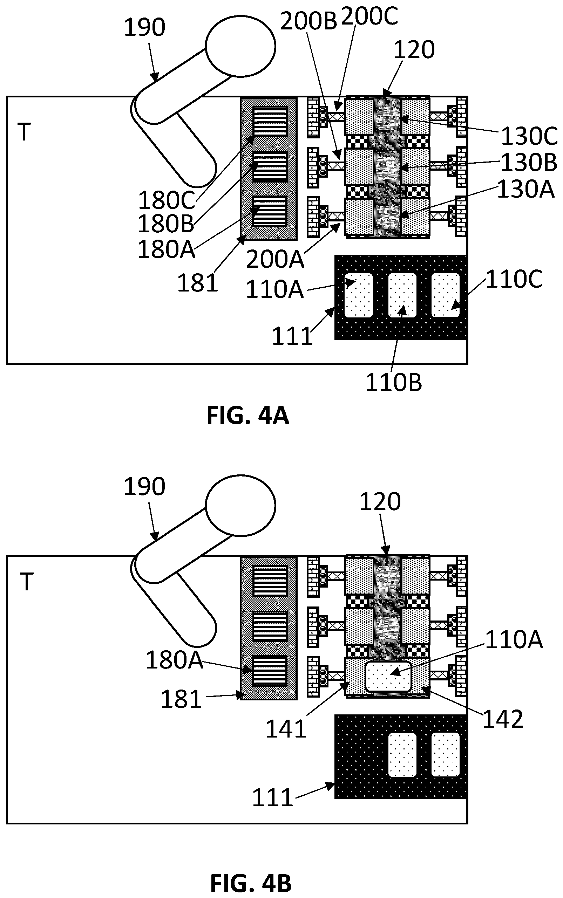

FIG. 4A to FIG. 4F illustrate a method or process for sintering a component to a carrier with the apparatus 200 according to another embodiment of the invention. In order to automatically place the component 110 onto the support members 141, 142 and the block 180 onto the top surface of the component 110, the apparatus 200 may further include a robotic transfer arm 190 for picking up and transferring the component 110 and the block 180.

Referring to FIG. 4A, three sets of apparatus 200A, 200B and 200C are installed on a working table T in this embodiment. Each apparatus 200A, 200B, 200C, which may have the same structure as the apparatus 200 as shown in FIG. 2, is configured for sintering one of the three components 110A, 110B, and 100C to the carrier 120. Sintering pastes 130A, 130B and 130C have been applied onto different areas of the carrier 120 for sintering the components 110A, 110B and 110C to the carrier 120. In addition, a component storage unit 111 may be provided on the working table T for holding the components 110A, 110B and 110C. A load storage unit 181 may also be provided on the working table T for holding at least one block for applying respective loads onto the components 110A, 110B and 110C during the sintering process. In this embodiment, the load storage unit 181 is configured to hold three blocks 180A, 180B, and 180C. Each block 180A, 180B, 180C is used for sintering one component 110A, 110B and 110C to the carrier 120.

Sintering a component 110A, 110B, 110C to the carrier 120 with the apparatus 200 according to this embodiment is illustrated using one component 110A as an example. The following steps 401 to 405 demonstrate the process for sintering the component 110A to the carrier 120.

In Step **401,** referring to FIG. 4A and FIG. 4B, the transfer arm 190 picks up the component 110A from the component storage unit 111 and places it onto the first and second support members 141 and 142 of the apparatus 200A. The support members 141 and 142 are located at positions P1 and P2 respectively at this time to support two opposite sides A and B of the component 110A.

Before conducting this step, if the support members 141 and 142 are located at positions P1' and P2' respectively, the actuators 152 and 152 of the apparatus 200A should move the support members 141 and 142 from positions P1' and P2' to positions P1 and P2, respectively.

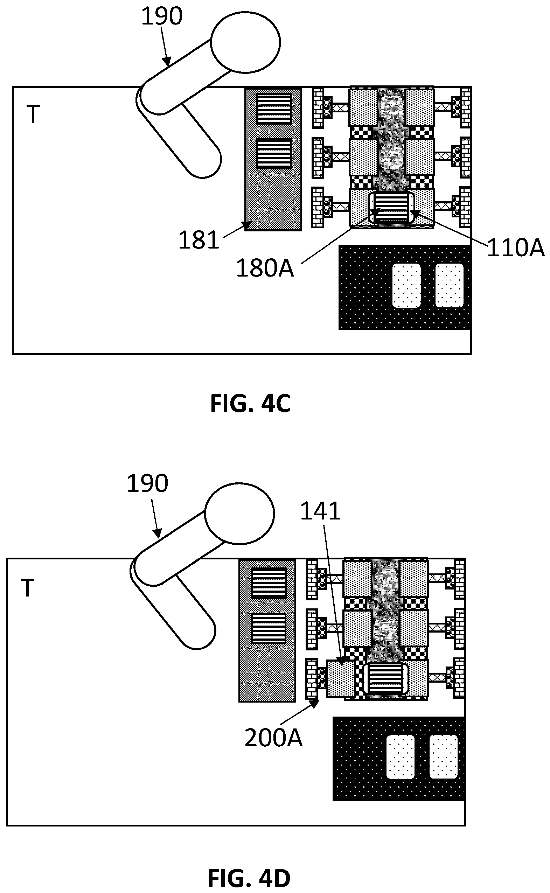

In Step **402,** referring to FIG. 4C, the transfer arm 190 picks up a block 180A from the load storage unit 181 and places it onto a top surface of the component 110A.

In Step **403,** referring to FIG. 4D, the first support member 141 of the apparatus 200A is moved from position P1 towards position P1' to allow a portion of the sintering surface 110a of the component 110A at or adjacent to side A to contact the sintering paste 130A that has been applied onto the carrier 120.

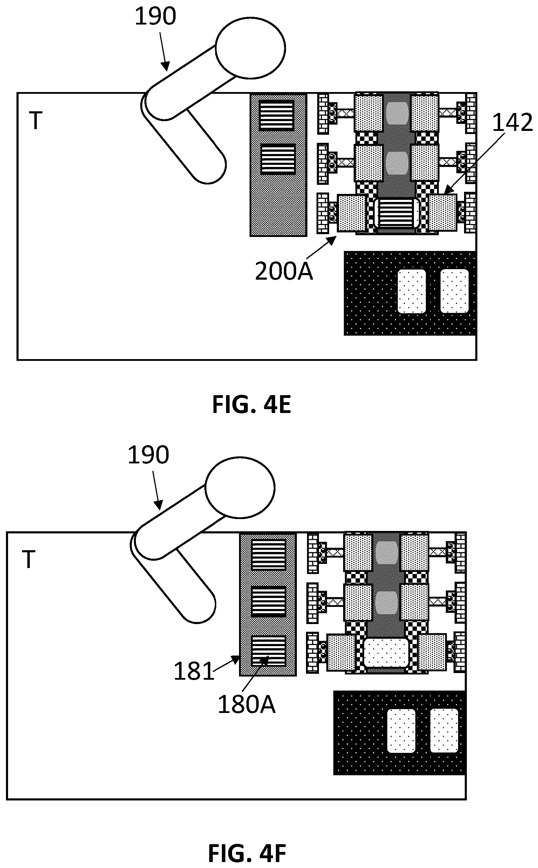

In Step **404,** referring to FIG. 4E, the second support member 142 of the apparatus 200A is moved from position P2 towards position P2' to gradually reduce a distance between side B of the component 110A and the carrier 120 so as to cause the remainder of the sintering surface 110a of the component 110A to contact the sintering paste 130A.

In Step **405,** referring to FIG. 4F, the transfer arm 190 picks up the block 180A from the top surface of the component 110A after the component 110A has been sintered to the carrier 120 and returns the block 180A to the load storage unit 181.

Similarly, the apparatus 200B may be used to sinter the component 110B to the carrier 120 via the sintering paste 130B, and the apparatus 200C may be used to sinter the component 110C to the carrier 120 via the sintering paste 130C.

The apparatus and method provided in the described embodiments of the invention allow gradual contact between a component and a sintering paste printed on a carrier by using a movable support mechanism. This support mechanism includes at least one movable support member that is configured to move between a supporting position to support the component and a non-supporting position. The advantage of this approach is that this keeps the sintering surface of the component tilted relative to the carrier during the placement of the component onto the sintering paste. Hence, the method and apparatus according to the embodiments of the invention avoid the entrapment of air between the component and the sintering paste, thus improving the quality and electrical performance of the sintered package and product.

Although the present invention has been described in considerable detail with reference to certain embodiments, other embodiments are possible. Therefore, the spirit and scope of the appended claims should not be limited to the description of the embodiments contained herein.

## Claims

1. A method for sintering a component to a carrier, the method comprising:
causing a portion of a sintering surface at or adjacent to a first side of the component to contact a sintering paste applied on the carrier when a second side of the component that is opposite to the first side is supported by a support mechanism such that the sintering surface of the component is tilted relative to the carrier,
moving the support mechanism from a first position where the supporting mechanism is supporting the second side of the component towards a second position to gradually reduce a distance between the second side of the component and the carrier so as to cause a remainder of the sintering surface of the component to contact the sintering paste, whereby air that is present between the component and the sintering paste is removed, and
sintering the component to the carrier when the remainder of the sintering surface of the component is resting on the sintering paste.

2. The method according to claim 1, wherein the support mechanism includes a first support member and a second support member, and the method further comprises the step of supporting the first side of the component on the first support member and supporting the second side on the second support member, prior to the portion of the sintering surface of the component at or adjacent to the first side contacting the sintering paste.

3. The method according to claim 2, further comprising moving the first support member from a third position where the first support member is supporting the first side of the component towards a fourth position to gradually reduce a distance between the first side of the component and the carrier so as to cause the portion of the sintering surface at or adjacent to the first side of the component to contact the sintering paste.

4. The method according to claim 2, wherein the first and/or second support member is wedged-shaped and has an inclined surface for contacting the first and/or second side of the component.

5. The method according to claim 3, wherein the step of moving the first and/or second support member comprises: driving the first and/or second support member with an actuator coupled thereto to move the first and/or second support member.

6. The method according to claim 1, further comprising: applying a load onto the component after the component is supported by the support mechanism.

7. The method according to claim 6, further comprising: removing the load from the component after the component has been sintered to the carrier.

8. The method according to claim 7, further comprising using a transfer arm to place the load onto the component and to remove the load from the component.

9. The method according to claim 6, wherein the load comprises a deadweight.

10. The method according to claim 1, further comprising: placing the component onto the support mechanism with a transfer arm, wherein the step of placing the component onto the support mechanism comprises picking up the component with the transfer arm and placing the component onto the support mechanism.

11. An apparatus for sintering a component to a carrier, the apparatus comprising:
a support mechanism configured to support a second side of the component that is opposite to a first side of the component when a portion of a sintering surface at or adjacent to the first side of the component is contacting a sintering paste applied on the carrier such that the sintering surface of the component is tilted relative to the carrier,
wherein the support mechanism is movable from a first position where the support mechanism is supporting the second side of the component towards a second position to gradually reduce a distance between the second side of the component and the carrier so as to cause a remainder of the sintering surface of the component to contact the sintering paste, whereby air that is present between the component and the sintering paste is removed, before the component is sintered to the carrier when the remainder of the sintering surface of the component is resting on the sintering paste.

12. The apparatus according to claim 11, wherein the support mechanism includes a first support member and a second support member, and the first support member is operative to support the first side of the component while the second support member is configured to support the second side of the component, prior to the portion of the sintering surface of the component at or adjacent to the first side contacting the sintering paste.

13. The apparatus according to claim 12, wherein the first support member is movable from a third position where the first support member is supporting the first side of the component towards a fourth position to gradually reduce a distance between the first side of the component and the carrier so as to cause the portion of the sintering surface at or adjacent to the first side of the component contact the sintering paste.

14. The apparatus according to claim 12, wherein the first and/or second support member is wedge-shaped and has an inclined surface for contacting the first and/or second side of the component.

15. The apparatus according to claim 11, further comprising an actuator coupled to the support mechanism, the actuator being operative to drive the support mechanism to move from the first position to the second position.

16. The apparatus according to claim 11, further comprising a transfer arm operative to place the component onto the support mechanism.

17. The apparatus according to claim 16, wherein the transfer arm is further operative to place a load on the component after the component is placed on the support mechanism.
